# EUROPÄISCHE PATENTANMELDUNG

(11) **EP 0 901 188 A2**
(43) Veröffentlichungstag der Anmeldung: **10.03.1999**
(21) Anmeldenummer: 98115364.6
(22) Anmeldetag: 14.08.1998
(51) Int. Cl.: H01R 9/09

(54) **Elektrischer Einpress-Bauteil, insbesondere Einpress-Steckverbinder, zur lötfreien Verbindung mit den durchkontaktierten Bohrungen einer Leiterplatte**

(30) Priorität: 08.09.1997 DE 19739212
(71) Anmelder: SIEMENS AKTIENGESELLSCHAFT, 80333 München (DE)
(72) Erfinder: Sterckx, Rix, 8020 Oostkamp (BE); Embo, Georges, 8920 Langemark (BE)

(57) **Zusammenfassung**

Zur Verbesserung der Kippbeständigkeit, wenn der Schwerpunkt des Einpreß-Bauteils außerhalb, insbesondere seitlich versetzt zur Einpreß-Kontaktanordnung liegt, wird vorgeschlagen, daß seitlich zur Einpreß-Kontaktanordnung zur schwereren Bauteilseite hin wenigstens ein am Kunststoffträger einstückig angebundener Stützzapfen (1) vorgesehen ist, wobei die Anbindung rings um den Stützzapfen (1) herum in Einpreßrichtung (vertikal zur Leiterplatte(8)) als Sollbruchstelle (9) ausgestaltet ist, und daß oberhalb des Stützzapfens (1) eine geschlossene Kavität (5) im Kunststoffträger vorgesehen ist.

## Beschreibung

Die Erfindung betrifft ein elektrisches Einpreß-Bauteil zur lötfreien Verbindung mit den durchkontaktierten Bohrungen einer Leiterplatte, mit einem Träger aus Kunststoff, welcher mit einer Einpreß-Kontaktanordnung zur Herstellung elektrischer Kontaktverbindungen versehen ist, wobei der Schwerpunkt des Einpreß-Bauteils außerhalb, insbesondere seitlich versetzt zur Einpreß-Kontaktanordnung liegt.

Bei der Leiterplattenverarbeitung gibt es eine zunehmende Tendenz, aus Gründen der Miniaturisierung sowie aus Umweltschutzgründen, die bisher übliche Schwall-Löttechnik zu verlassen. Hierzu werden vermehrt Bauteile in Einpreßtechnik angeboten. Diese Bauteile werden meistens manuell vorbestückt und anschließend mittels einer Presse in die Leiterplatte eingepreßt. Die neue Einpreßtechnik bietet sich besonders, aber nicht nur, für 90° abgewinkelte Steckverbinder an, wie sie aus der Deutschen Offenlegungsschrift DE 196 07 548 A1 oder aus der Deutschen Patentschrift DE 33 18 135 C2 bekannt sind.

Hei diesen Bauteilen, insbesondere bei abgewinkelten Einpreß-Steckverbindern, passiert es häufig, daß der Schwerpunkt des gesamten Bauteils oberhalb oder sogar außerhalb der Kontaktreihen liegt. Die hierdurch entstehende mehr oder weniger große Kipptendenz kann dann zum Umkippen des Bauteils schon während des Vorbestückens oder im weiteren Arbeitsablauf, z. B. beim Verpressen, führen. Bisher sind nur aufwendige, beziehungsweise zu neuen Problemen führende Verhinderungsmaßnahmen bekannt. Beispielsweise ist es natürlich grundsätzlich möglich, die Bauteile in einen Vorbestückrahmen aufzunehmen, der jedoch spezifisch je nach Leiterplatte und Bauteiltype anzufertigen ist. Prinzipiell könnte das Problem auch über die Ausgestaltung der Einpreßpins angegangen werden, die sich dazu bereits bei der Vorbestückung durch ausreichende Kraftausübung in den Leiterplattenlöchern 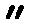 festbeißen" müßten. Die Kraftausübung ist jedoch vom Handling abhängig und deshalb nicht konstant. Insgesamt ist diese Methode nicht zuverlässig genug. Eine weitere Möglichkeit bestünde darin, an der schwereren Bauteilseite Stützen in Form mitangespritzter Kunststoffzapfen oder metallischer Inserts vorzusehen, die zugleich mit dem Bauteil eingepreßt werden. Dazu sind jedoch entsprechende Löcher in der Leiterplatte vorzusehen. Diese können für das Leiterplatten-Layout und für die oftmals genormten Hauteilformen störend sein.

Der Erfindung liegt die Aufgabe zugrunde, ein verbessertes Einpreß-Bauteil der eingangs genannten Art zu schaffen, das weniger kippanfällig ist und die zuvor genannten Nachteile vermeidet.

Diese Aufgabe wird erfindungsgemäß dadurch gelöst, daß seitlich zur Einpreß-Kontaktanordnung zur schwereren Bauteilseite hin wenigstens ein am Kunststoffträger einstückig angebundener Stützzapfen vorgesehen ist, wobei die Anbindung rings um den Stützzapfen herum in Einpreßrichtung (vertikal zur Leiterplatte) als Sollbruchstelle ausgebildet ist, und daß oberhalb des Stützzapfens eine geschlossene Kavität im Kunststoffträger vorgesehen ist.

Bei einer besonders vorteilhaften Weiterbildung der Erfindung ist das elektrische Einpreß-Bauteil durch einen 90° abgewinkelten Einpreß-Steckverbinder gebildet, bei dem die Kontakte der Einpreß-Kontaktanordnung mit einem Ende in einem im wesentlichen quaderförmigen Kunststoffkörper befestigt und in einem U-förmigen Preßteil in schlitzartigen, zur Leiterplatte hin offenen Aussparungen seitlich geführt sind und an ihrem freien Ende einen rechtwinklig zur Leiterplatte hin abgebogenen Einpreßabschnitt aufweisen, der jeweils mit zwei Einpreßschultern versehen ist, wobei das Preßteil mit zur Leiterplatte parallelen, neben den Aussparungen angeordneten Einpreßflächen ausgebildet ist, die beim Einpressen mit den Einpreßschultern zusammenwirken, und bei der das Steckgesicht des Steckverbinders durch ein Schirmblech gebildet ist, wobei der Stützzapfen am Preßteil zwischen den in Reihen angeordneten Kontakten und dem zwischen den U-Schenkeln des Preßteils angeordneten Kunststoffkörper angebunden ist.

Die Erfindung wird nachfolgend an einem Ausführungsbeispiel anhand der Figuren der Zeichnung näher erläutert:

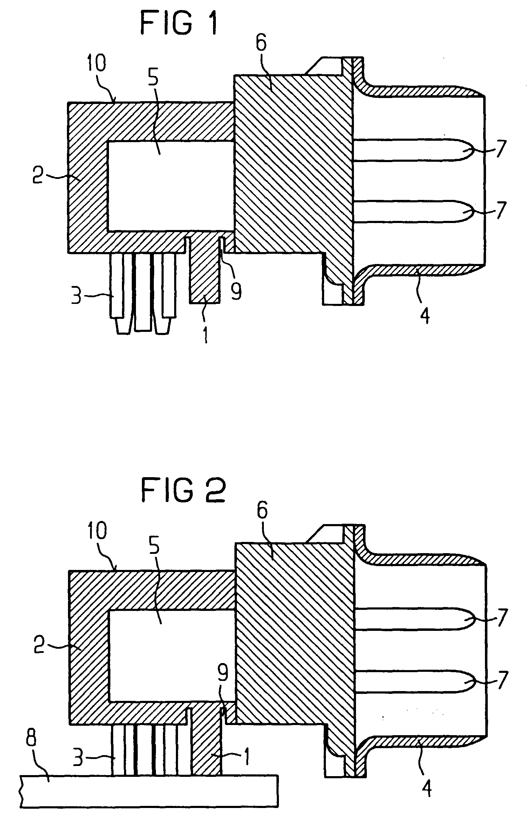

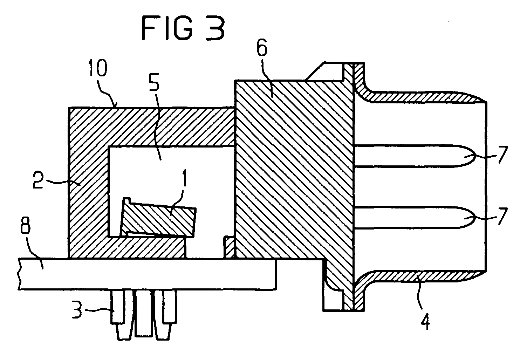

- Figuren 1 bis 3: zeigen, jeweils in seitlicher Querschnittsdarstellung, einen erfindungsgemäßen Einpreß-Steckverbinder in drei verschiedenen Montagezuständen.

In Figur 1 ist schematisiert dargestellter ein abgewinkelter Einpreß-Steckverbinder dargestellt, der aus einem leichteren, linken Teil und einem schwereren, rechten Teil besteht. Der schwerere Teil ist im wesentlichen aus dem Schirmblech 4 und einem etwa quaderförmigen Kunststoffkörper 6 zusammengesetzt, während der leichtere Teil durch ein U-förmiges Preßteil 2 gegeben ist. Heide Teile bilden eine Steckverbinder-Einheit, vor allem durch die zwei Reihen von abgewinkelten Kontaktstiften, die mit ihren freien Enden 7 eine parallel zur Leiterplatte 8 ausgerichtete Messer- oder Buchsenleiste bilden, während ihre entgegengesetzten, abgewinkelten Enden Einpreßabschnitte aufweisen. Die Einpreßabschnitte sind in den Figuren 1 bis 3 nicht erkennbar, da die beiden nebeneinanderliegenden Anschlußreihen durch den außen am Preßteil angeformten Befestigungszapfen 3 verdeckt sind. Zu Einzelheiten dieses speziellen Steckverbinders vgl. die eingangs genannten Offenlegungsschrift. Erkennbar in Figur 1 ist außerdem der Stützzapfen 1 und die umlaufende Sollbruchstelle bzw. Nut 9. Die Anbindung des Stützzapfens 1 an das Preßteil 2 ist erkennbar durch die Nut 9 ringsum in der Dicke als Sollbruchstelle gestaltet. Oberhalb des Stützzapfens 1 ist im Preßteil 2 eine zunächst noch völlig verschlossene Kavität 5 vorgesehen.

In Figur 2 ist der Einpreß-Steckverbinder im Vorbestückungszustand auf einer Leiterplatte 8 dargestellt. Der Steckverbinder stützt sich auf die Kontaktreihen und auf die Stützzapfen 1 und ist dadurch im Kräftegleichgewicht. Die Spitzen der Einpreßabschnitte stecken bereits in den Leiterplattenlöchern und führen dadurch den Steckverbinder.

Beim Einpressen des Steckverbinders, normalerweise über die Deckfläche 10 des Preßteils 2, werden die Einpreß-Kontakte in die Leiterplatte eingedrückt. Unter der auftretenden vertikalen Kraft scheren die nicht notwendigerweise runden Stützzapfen 1 ab und werden in die Kavität 5 eingedrückt. Wichtig und vorteilhaft ist dabei, daß es nicht zu einem mehr oder weniger beliebigen Abbrechen der Stützzapfen 1 kommt, da diese in diesem Fall zur Seite abbiegen und unter das Einpreß-Bauteil geraten könnten. Weil die Kavität 5 bei Aufliegen des Steckverbinders auf der Leiterplatte 8 immer noch geschlossen ist, verbleiben die abgescherten Stützzapfen 1 in ihr, können also nicht heraus- bzw. herunterfallen und Störungen verursachen. Die vorgeschlagene kippverhindernde Hilfskonstruktion in Form von Stützzapfen 1 ist mit geringem Aufwand für den Steckerhersteller und großem funktionellem Nutzen für den Bestücker verbunden. Die Stützzapfen beeinflussen in keiner Weise das Leiterplatten-Layout, sie können sich später nicht lockern und sie bedeuten keinen Mehraufwand.

## Patentansprüche

1. Elektrisches Einpreß-Bauteil zur lötfreien Verbindung mit den durchkontaktierten Bohrungen einer Leiterplatte (8), mit einem Träger aus Kunststoff, welcher mit einer Einpreß-Kontaktanordnung zur Herstellung elektrischer Kontaktverbindungen versehen ist, wobei der Schwerpunkt des Einpreß-Bauteils außerhalb, insbesondere seitlich versetzt zur Einpreß-Kontaktanordnung liegt,
**dadurch gekennzeichnet,**
daß seitlich zur Einpreß-Kontaktanordnung zur schwereren Bauteilseite hin wenigstens ein am Kunststoffträger einstückig angebundener Stützzapfen (1) vorgesehen ist, wobei die Anbindung rings um den Stützzapfen (1) herum in Einpreßrichtung (vertikal zur Leiterplatte(8)) als Sollbruchstelle (9) ausgestaltet ist, und daß oberhalb des Stützzapfens (1) eine geschlossene Kavität (5) im Kunststoffträger vorgesehen ist.

2. Elektrisches Einpreß-Bauteil nach Anspruch 1,
**dadurch gekennzeichnet,**
daß das Bauteil durch einen 90° abgewinkelten Einpreß-Steckverbinder gebildet ist, bei dem die Kontakte der Einpreß-Kontaktanordnung mit einem Ende in einem im wesentlichen quaderförmigen Kunststoffkörper (6) befestigt und in einem U-förmigen Preßteil (2) in schlitzartige, zur Leiterplatte (8) hin offenen Aussparungen seitlich geführt sind und an ihrem freien Ende (7) einen rechtwinklig zur Leiterplatte (8) hin abgebogenen Einpreßabschnitt aufweisen, der jeweils mit zwei Einpreßschultern versehen ist, wobei das Preßteil (2) mit zur Leiterplatte parallelen, neben den Aussparungen angeordneten Einpreßflächen ausgebildet ist, die beim Einpressen mit den Einpreßschultern zusammenwirken und bei der das Steckgesicht des Steckverbinders durch ein Schirmblech (4) gebildet ist, wobei der Stützzapfen (1) am Preßteil (2) zwischen den in Reihen angeordneten Kontakten und dem zwischen den U-Schenkeln des Preßteils (2) angeordneten Kunststoffkörper (6) angebunden ist.
